(19)

Europäisches
Patentamt
European
Patent Office
Office européen
des brevets

(11) **EP 3 637 574 B1**

(12) **EUROPEAN PATENT SPECIFICATION**

(45) Date of publication and mention
of the grant of the patent:
**21.02.2024  Bulletin 2024/08**

(21) Application number: **18382728.6**

(22) Date of filing: **11.10.2018**

(51) International Patent Classification (IPC):
*H02J 3/38* (2006.01)     *G01R 19/25* (2006.01)

(52) Cooperative Patent Classification (CPC):
**H02J 3/38; H02J 3/388;** G01R 19/2513;
H02J 2203/20; Y02E 60/00; Y04S 40/20

(54) **METHOD FOR ESTIMATING ELECTRICAL PARAMETERS OF A GRID**

VERFAHREN ZUR SCHÄTZUNG DER ELEKTRISCHEN PARAMETER EINES STROMNETZES

PROCÉDÉ D'ESTIMATION DES PARAMÈTRES ÉLECTRIQUES D'UN RÉSEAU ÉLECTRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**15.04.2020  Bulletin 2020/16**

(73) Proprietor: **Universidade de Vigo**
**36310 Vigo (ES)**

(72) Inventors:
• **PÉREZ ESTÉVEZ, Diego**
**36209 Vigo, Pontevedra (ES)**
• **DOVAL GANDOY, Jesús**
**36203 Vigo, Pontevedra (ES)**

(74) Representative: **ABG Intellectual Property Law,
S.L.**
**Avenida de Burgos, 16D**
**Edificio Euromor**
**28036 Madrid (ES)**

(56) References cited:
EP-A1- 2 827 157        CN-A- 108 448 608
US-A1- 2016 252 588

• **JING YUAN ET AL: "An Adaptive Digital Notch
Filter Based on Grid Impedance Estimation for
Improving LCL Filter Peformance", 2018
IEEE/PES TRANSMISSION AND DISTRIBUTION
CONFERENCE AND EXPOSITION (T&D), IEEE, 16
April 2018 (2018-04-16), pages 1-5, XP033390904,
DOI: 10.1109/TDC.2018.8440296 [retrieved on
2018-08-17]**
• **PEREZ-ESTEVEZ DIEGO ET AL: "Enhanced
Resonant Current Controller for Grid-Connected
Converters With LCL Filter", IEEE
TRANSACTIONS ON POWER ELECTRONICS,
INSTITUTE OF ELECTRICAL AND ELECTRONICS
ENGINEERS, USA, vol. 33, no. 5, 1 May 2018
(2018-05-01), pages 3765-3778, XP011676929,
ISSN: 0885-8993, DOI:
10.1109/TPEL.2017.2770218 [retrieved on
2018-02-05]**
• **COBRECES S ET AL: "Complex-space recursive
least squares power system identification",
POWER ELECTRONICS SPECIALISTS
CONFERENCE, 2007. PESC 2007. IEEE, IEEE,
PISCATAWAY, NJ, USA, 17 June 2007
(2007-06-17), pages 2478-2484, XP031218653,
ISBN: 978-1-4244-0654-8**
• **LISERRE M ET AL: "Grid Impedance Estimation
via Excitation of -Filter Resonance", IEEE
TRANSACTIONS ON INDUSTRY APPLICATIONS,
IEEE SERVICE CENTER, PISCATAWAY, NJ, US,
vol. 43, no. 5, 1 September 2007 (2007-09-01),
pages 1401-1407, XP011192489, ISSN: 0093-9994,
DOI: 10.1109/TIA.2007.904439**

**Description**

## TECHNICAL FIELD OF THE INVENTION

This invention belongs to the technical field of the estimation of electrical parameters of a grid and, more particularly, to the field of detection of islanding conditions and tuning of a power converter connected to said grid based on said estimated parameters.

## BACKGROUND OF THE INVENTION

Grid-tied inverters, which are a type of power converter, can be connected to a main grid or to a micro-grid by means of LCL filters. It should be understood that the micro-grid is an element of the main grid. They are commonly commanded by digital linear controllers that may contain current controllers which, due to the high-order dynamics and the presence of a resonant mode of the LCL filter, suffer reductions in their stability margins. On contrary, the LCL filters are gaining popularity thanks to its advantages in terms of switching noise attenuation compared to L filters with the same total inductance.

Specifically, during operation of a voltage source converter or VSC, the current controller experiences a lack of performance or even instability when the setup parameters, which are used for the tuning, deviate from their nominal values. The setup parameters which model the physical system are the LCL filter reactive values, the electrical parameters of the grid and the Equivalent Series Resistance ($R_{ESR}$) of the VSC.

During the operation of a power converter it must be taken into account the presence of any islanding condition in a micro-grid, which should be understood as the situation in which the power converter powers a micro-grid to which it is connected while the main grid is disabled. Islanding can be dangerous to utility workers, who may not realize that the micro-grid is still powered. Thus, detecting such islanding conditions is essential to avoid accidents.

Various methods have been developed to identify the setup parameters during operation of the VSC to detect islanding conditions and to adjust the tuning of the current controller to, therefore, recover its nominal performance.

These methods can be classified into two main categories:

- methods that inject a periodic signal, such the document EP2827157 A1, wherein a fundamental frequency signal is injected to perform the estimation, and

- methods which inject a non-periodic signal, for example the document EP1643256 A1, that discloses a method that forces a voltage sag in the grid voltage waveform by connecting a very low impedance load during a short period of time and the estimation of the grid impedance is obtained by measuring the disturbed voltage waveform.

The problem involved in such methods is the perturbation to which the grid is subjected. The injection of a signal introduces harmonic components that can affect other systems connected to the grid or the micro-grid. Such systems may have means of protection; that is, when they detect the presence of harmonic components, they disconnect themselves from the grid in order not to be damaged. In this way, although they cannot be affected by perturbations, in practice the efficiency of the system is diminished.

Patent document US 2016/252588 A1 teaches the use of state observers, that emulate and observe a section of an inverter coupled to the grid through an LCL filter, to estimate the grid impedance.

The article "An adaptive digital notch filter based on grid impedance estimation for improving LCL filter performance" published in the name of Jing Yuan teaches the use of a recursive least squares algorithm for estimating the grid impedance.

The article "Complex-space recursive least squares power system identification" published in the name of Cobreces teaches a general recursive least squares algorithm for estimating the grid impedance from the current and voltage measurements performed at the common coupling point.

The article *"Grid Impedance Estimation via Excitation of Filter Resonance"* published in the name of M. Liserre proposes a grid impedance estimation method based on the injection of an excitation signal. However, this method alters the normal operation of a power converter to obtain a measurement of the grid impedance and is applicable to converters that use a PWM modulator.

The present invention solves the previous problems by means of an effective method for estimating the impedance of the grid without injecting additional signals superimposed to the input voltage of the power converter.

## SUMMARY OF THE INVENTION

The present invention provides an alternative solution for the aforementioned problems by a method for estimating the electrical parameters of a grid according to claim 1, a method for detecting islanding conditions according to claim 7, a system according to claim 11, a computer program according to claim 14 and a computer-readable medium according to claim 15.

Throughout this entire document, parameters that are related according to an equation are used. Thus, there are many ways of expressing explicit or implicitly the dependence among such variables, being the more generic form $f(x_1, x_2, x_3,...) = 0$. These equations represent a functional relation between variables so that, when the values adopted by the resulting variables are the same, both expressions must be considered as equivalents.

In a first inventive aspect, the invention provides a method for estimating the electrical parameters of a grid according to claim 1.

The method of the first inventive aspect may be also understood as a method implemented and executed by a processor, microprocessor, computer or any other device or system able to store and process information, i.e., a computer implemented method.

Firstly, the method comprises the stage of providing a power converter and an LCL filter. Throughout this entire document, "power converter" will be understood as an electrical device for converting electrical energy. This term encompasses from simple transformers that change the voltage of AC power to DC -or vice versa- to systems of great complexity. On the other hand, as "LCL filter" it must be understood a third-order filter that comprises two inductors and a capacitor. The use of such filters to connect a power converter to a grid has the advantage of filtering the harmonic components absorbed by the power converter while it is connected to said grid.

Next, the method comprises the stage of providing a digital controller comprising processing means configured to estimate the electrical parameters of a grid, that is, said processing means comprised in the digital controller are configured to execute the method of the present invention. Particularly, "digital controller" may be understood as a processing means wherein the method is implemented and executed.

Such digital controller estimates in step a) the transfer function of the whole system; that is, the combination of the power converter, the LCL filter and the electrical grid. The estimation is done in real-time, i.e., while the power converter is operating and connected to the micro-grid. As transfer function we will understand the equation defining the relation between the measured grid-side current $i_1$ and the power converter output voltage $v$. A person skilled in the art can notice that this relation can be expressed as a zero-pole-gain model.

The method continues in step b) by separating the transfer function by the digital controller in two different factors, known and unknown. It involves the advantage of working with simpler expressions decreasing the calculation complexity.

After that, the digital controller converts the equation of the unknown factor of the transfer function into a rational expression with several unknown coefficients in step c). In step d), the digital controller estimates these coefficients by means of an estimation algorithm "recursive least squares" or RLS. This algorithm will be understood as an algorithm that receives two signals $i_f$ and $v_f$, $i_f$ being the measured grid-side current $i_1$ filtered by a notch filter and $v_f$ being the power converter output voltage v filtered also by a notch filter and by the known factor calculated in step b), to estimate the coefficients of a function, i.e. the rational expression of the unknown factor, that are the best adjusted for such signals. The term "recursive" refers to the memory of the algorithm; that is, during its execution it considers not only the current signal samples received but also the samples of the previous moments of time.

Throughout this entire document, "the fundamental frequency of the grid" will be understood as the frequency at which the grid reaches the greatest amplitude, preferably 50 or 60 Hz, and as "notch filter" will be understood a band-stop filter that attenuates the frequencies that belong to a narrow band.

The final stage of the method, step e), comprises obtaining the electrical parameters of the grid by the digital controller taking into account the above mentioned coefficients, considering DC conditions, connecting and disconnecting the power converter from the grid and applying the known values of the LCL filter components and the sampling period of the power converter. Throughout this entire document, "sampling period" will be understood as the known period at which the power converter works; e.g., the RLS algorithm is executed with this periodicity. A person skilled in the art would know the period is the inverse of the frequency, being the term "sampling frequency" equivalent by only performing the inverse of the period. In a particular example, the sampling frequency belongs to the range 1 kHz to 100 kHz.

The main advantage of the method of the invention is that it is not necessary to inject any signal to the grid that would lead to harmonic components that can affect other systems connected to such grid. In this way, it is possible to improve the yield of the system despite the required LCL filter and to detect islanding conditions to protect the utility workers while the efficiency of the system is maintained.

In a particular embodiment, *the method further comprises a sub-step between the stages* d-ii) and d-iii) *of filtering $v_f$ and $i_f$ with a low-pass filter.*

Throughout this entire document, "low-pass filter" will be understood as a filter that passes the frequencies below a certain threshold and attenuates the frequencies above such threshold. The use of low-pass filters involves the advantage of eliminating undesired high-frequency components, e.g., noise.

In a particular embodiment, *the power converter is a voltage source converter, VSC, modeled as a zero order*

*hold, ZOH, in series with the equivalent series resistance $R_{ESR}$.*

Throughout this entire document, "Voltage Source Converter" will be understood as a converter that generates an amplitude and phase variable alternating voltage from a continuous voltage; "zero order hold" will be understood as a mathematical model of a DC-AC converter for transforming a discrete-time signal to a continuous-time signal by holding each sample value for one sample interval; and "equivalent series resistance" will be understood as a component that, together with other capacitors and inductors, models approximately the behavior of an electric circuit.

In a particular embodiment, *the method further comprises the following steps:*

- *readjusting the intrinsic parameters of the current controller based on the calculated physical parameters,*
- *after an optimization period, $t_o$, performing the steps a) to e) of the method obtaining an update of the physical parameters and performing the previous step with the updated physical parameters.*

The intrinsic parameters of the current controller should be understood as the parameters that define its bandwidth and its robustness. Advantageously, the method for estimating the grid impedance is used to readjust periodically some parameters of the current controller to improve the transient response and the steady state performance. The periodicity is defined by means of an optimization period, which is selectable. In a particular example, such optimization period is five seconds.

The intrinsic parameters of the current controller that are modified define its bandwidth and its robustness. They are variable, that is, they depend on the type of current controller comprised in the digital controller.

In a particular embodiment, *the intrinsic parameters of the current controller are a proportional gain $K_p$ and an integral gain $K_i$.*

When the digital controller is a proportional-integral controller, PI, or a proportional-resonant controller, PR, the parameters of its current controller that can be readjusted according to the grid impedance estimated are two types of gains: a proportional gain $K_p$ and an integral gain $K_i$.

Throughout this entire document, "proportional-integral" controller will be understood as a first-order controller and "proportional-resonant" as a second-order controller. The order of a controller is the highest order of the differential equation that describes such controller or, equivalently, the number of poles of its transfer function.

When the digital controller used is a high-order one, i.e., at least third order; e.g. a controller in state-space or a predictive controller, the parameters that can be readjusted are the equations that describe its plant model. Here, the parameters $R_g$ and $L_g$ are updated according to the values obtained by the method.

In a particular embodiment, *in steps a) and e-ii) the power converter is connected to the grid by means of a switch element and in step e-i) the power converter is disconnected from the grid and short circuit its output by means of said switch element.*

Throughout this entire document, "switch element" will be understood as a device configured to interrupt the current of an electrical circuit or to divert it from one conductor to another.

The switch permits to connect and disconnect the power converter from the grid quickly and easily.

In a second inventive aspect, the invention provides a *method for detecting islanding conditions of a grid comprising the following steps:*

*1) performing the method for estimating the electrical parameters of the grid according to any of the embodiments of the first inventive aspect,*
*2) storing the physical parameters within a memory,*
*3) after a determination period, $t_d$, performing the steps a) to e) of the method for estimating the electrical parameters of a grid according to any of the embodiments of the first inventive aspect, obtaining an update of the physical parameters,*
*4) comparing the stored physical parameters and the updated physical parameters,*
*5) if the variations between the stored physical parameters and the updated physical parameters are greater than a threshold, emitting an alarm, as islanding conditions are detected.*

In one embodiment, *if the variations between the physical parameters and the updated physical parameters are lower or equal than the threshold, iteratively performing the following steps:*

*i) storing the updated physical parameters, and*
*ii) repeating the steps 3) to 5) until the stored physical parameters and the updated physical parameters are greater than the threshold.*

It can be appreciated that step 4) of the above previous embodiments a comparison is performed between the stored physical parameters and the updated physical parameters. In the case of the first embodiment, the stored physical parameters are referred to the parameters stored in step 2). In the case of second embodiment, the stored physical parameters are referred to the parameters stored in step i). In both cases the *stored physical parameters* used in step 4) are referred to the last stored physical parameters by any of the embodiments of the method of the second inventive aspect.

The method of the second inventive aspect may be also understood as a method implemented and executed by a processor, microprocessor, computer or any other device or system able to store and process information, i.e., a computer implemented method.

Throughout this entire document, "memory" will be understood as any type of device configured to store information, i.e., storage data means. Some particular examples are a server, a hard drive or a pen drive. Besides, "alarm" will be understood as a notification or information generated when the variation in the parameters is greater than a threshold.

Advantageously, the method for estimating the grid impedance is used to detect periodically variations in such grid impedance. According to different norms, when a variation in the grid impedance is greater than a certain threshold, islanding condition exists. Most popular norms used are:

- IEEE 929-2000: islanding conditions are detected when a variation in the grid impedance is equal or greater than the base impedance of the power converter in less than ten cycles of the grid fundamental frequency.
- VDE 0126-1-1: islanding conditions are detected when the grid impedance rises in 1 ohm when detection is done in less than 5 seconds.
- EN 50330: the power converter must be disconnected from the grid in less than 5 seconds when the grid impedance variates 0.5 resistive ohms.

In a particular example, the norm IEEE 929-2000 is imposed. In other particular example, the norm VDE 0126-1-1 is used to define the requisites for detecting islanding conditions. In a third particular example, the norm EN 50330 is applied to detect islanding conditions.

The periodicity for measuring the grid impedance variation is defined by means of a "determination period", which is selectable within a certain margin according to the specific norm used. In the same way, the threshold that decides if islanding conditions exist also is specific of each norm.

In a particular example, the alarm is received by a utility worker being informed about the existence of islanding conditions in order to avoid accidents.

In a particular embodiment, *the last step of the method further comprises disconnecting the power converter from the grid.*

In a more advantageous way, the power converter is disconnected from the grid when islanding conditions are detected so that accidents are avoided.

In a particular embodiment, $t_d$ *is from one millisecond to five seconds and/or the threshold is from 0. 1 to 1 ohms.*

As it was explained before, the determination period is selectable within a certain margin according to the specific norm used. The margin of periods of this particular embodiment encompasses all the possible periods imposed in the most popular norms described above.

In a particular example, the norm IEEE 929-2000 is imposed with a determination period lower than ten cycles of the grid fundamental frequency. In other particular example, the norm VDE 0126-1-1 is used with a determination period of less than 5 seconds. In a third particular example, the norm EN 50330 is applied with a determination period of less than 5 seconds.

The threshold that decides if islanding condition exists depends on the specific norm used. The margin of thresholds of this particular embodiment encompasses all the possible thresholds imposed in the most popular norms described above.

In a particular example, the norm IEEE 929-2000 is imposed with a threshold equal to the base impedance of the power converter. In other particular example, the norm VDE 0126-1-1 is used with a threshold of 1 ohm. In a third particular example, the norm EN 50330 is applied with a threshold of 0.5 ohms.

In other embodiment according to the first inventive aspect, the method of the first inventive aspect further comprises the steps of any of the embodiments of the second inventive aspect.

In a third inventive aspect, the invention provides *a system* adapted to estimate *the electrical parameters of a grid comprising a power converter, an LCL filter, a digital controller and means configured to*

- *perform steps of the method of any of the embodiments of the first inventive aspect, and/or*
- *perform steps of the method of any of the embodiments of the second inventive aspect.*

In a particular embodiment, *the digital controller comprises a noise-shaped modulator, a phase locked loop or PLL, at least one reference frame transformation element, a current controller and a grid impedance identification element.*

Throughout this entire document, it should be understood the following interpretation for the following terms:

- "noise-shaped modulator" as a module that converts a continuous-amplitude signal to a voltage that is synthesizable by a power converter.
- "phase locked loop" as a control system that generates an output signal whose phase is related to the phase of an input signal.

  - "reference frame transformation element" as a mathematical operation, useful to simplify the analysis of three-phase circuits, which transforms a three-element vector into a complex number employed. Said simplification are described on the following documents of the prior art:

    ◦ R. H. Park, "Two-reaction theory of synchronous machines generalized method of analysis-part I," in Transactions of the American Institute of Electrical Engineers, vol. 48, no. 3, pp. 716-727, July 1929. doi: 10.1109/T-AIEE.1929.5055275, and
    ◦ Clarke, E., Circuit Analysis of AC Power Systems, Vol. 1, New York: John Wiley & Sons, Inc., 1950.

- "current controller" as the module that minimizes the error between the measured grid-side current $i_1$ and a reference current, being such reference current the one that must be provided to the grid by the power converter.
- "grid impedance identification element" as a module that estimates the impedance of a grid according to the method explained above.

All these modules comprised in the digital controller works sequentially.

In a particular embodiment, *the noise-shaped modulator is configured to generate the reference voltage v that the power converter generates at its output.*

The input signals of the digital controller are the measurements of the current and voltage of the grid and its output are the triggering signals that enable the transistors of the power converter. Thus, the current controller is configured to control the current injected to the grid.

Internally, the digital controller executes the PLL to obtain the phase of the grid voltage. After that, it transforms the reference current and the measured grid current using a reference frame transformation element and executes the current controller to obtain a modulating signal. Such signal is then converted into a synthesizable vector by the noise-shaped modulator. Afterward, the digital controller converts such vector into the triggering signals of the transistors of the power converter. Finally, it estimates the grid impedance by means of the grid impedance identification element.

In a forth inventive aspect, the invention provides *a computer program comprising instructions to cause the third inventive aspect to*

- *execute the steps of the method of any of the embodiments of the first inventive aspect, and/or*
- *execute the steps of the method of the embodiments of the second inventive aspect*

In a fifth inventive aspect, the invention provides *a computer-readable medium having stored thereon the computer program of the forth inventive aspect.*

## DESCRIPTION OF THE DRAWINGS

These and other characteristics and advantages of the invention will become clearly understood in view of the detailed description of the invention which becomes apparent from a preferred embodiment of the invention, given just as an example and not being limited thereto, with reference to the drawings.

Figure 1a    This figure shows a flowchart of the method for estimating the electrical parameters of a grid.
Figure 1b    This figure shows a flowchart of the method for estimating the electrical parameters of a grid with an extra filtering step.
Figure 2a    This figure shows a flowchart to readjust the parameters of the current controller when such current controller is an proportional-integral controller.
Figure 2b    This figure shows a flowchart to readjust the parameters of the current controller when such current controller is an state-space controller.
Figure 3    This figure shows a flowchart to detect islanding conditions periodically.
Figure 4    This figure shows a simulation model of the components needed for estimating the electrical parameters of a grid.
Figure 5    This figure shows an electrical scheme of components needed for estimating the electrical parameters of a grid wherein the modules of the digital controller are detailed.

## DETAILED DESCRIPTION OF THE INVENTION

The present invention, according to a first inventive aspect, provides a method (100) for estimating the electrical parameters of a grid (1). In the following examples, the electrical parameters comprise a resistive $R_g$ and a reactive $j\omega_g L_g$ components of the grid impedance $Z_g$ (2), where $\omega_g$ is the grid angular frequency in radians per second. Additionally, the electrical grid is modeled as an AC-voltage source $v_g$ (3) in series with the impedance $Z_g$ (2), and a current $i_1$ (4) flows through $Z_g$ (2).

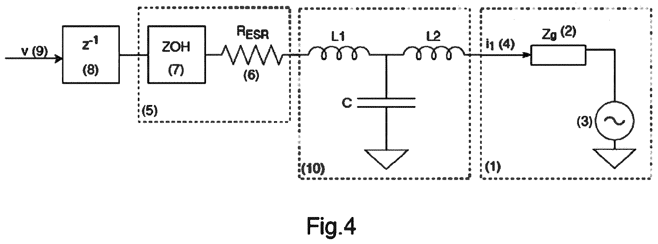

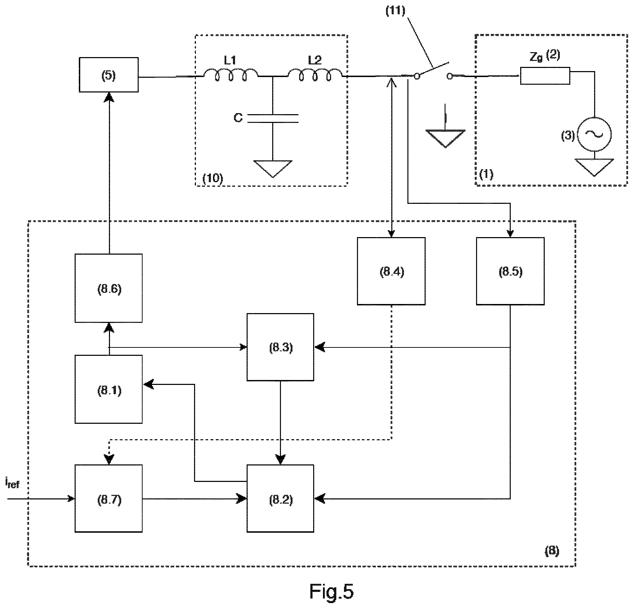

Down below, examples of the method of invention are described using any of the components described in figures 4 and/or 5.

In particular, the example of figure 4 describes the simulation model where the method can be implemented or simulated. More particularly, it comprises a digital controller (8) implemented in a dSPACE platform working at a sampling frequency of 10kHz, a power converter (5) of the type two-level voltage-source converter (VSC) and an LCL filter. Further the power converter is modeled as a zero order hold (7) and the power converter equivalent series resistance $R_{ESR}$ (6) is 1.5 Ohms.

Regarding the system of figure 5 used, it comprises a digital controller (8) described on D. Perez-Estevez, J. Doval-Gandoy, A. G. Yepes, O. Lopez and F. Baneira, "Generalized Multi-Frequency Current Controller for Grid-Connected Converters With LCL Filter," in IEEE Transactions on Industry Applications, doi: 10.1109/TIA.2018.2829459. Additionally, the system of figure 5 further comprises a power converter (5) of the type previously indicated, an LCL filter (10) and a power switch (10) of the type single pole double throw. The power converter comprises a voltage source converter, VSC, and the power converter equivalent series resistance $R_{ESR}$ (6), not shown in figure 5, is 1.5 Ohms.

Further, the digital controller (8) comprises a current controller (8.2) described on D. Perez-Estevez, J. Doval-Gandoy, A. G. Yepes, O. Lopez and F. Baneira, "Generalized Multi-Frequency Current Controller for Grid-Connected Converters With LCL Filter," in IEEE Transactions on Industry Applications, doi: 10.1109/TIA.2018.2829459. Additionally the digital controller (8) further comprises, a noise-shaped modulator (8.1) with a third order filter, a grid impedance identification block (8.3) of the type described in this document, a low-bandwidth phase locked loop (8.4), PLL, described on F. D. Freijedo, J. Doval-Gandoy, O. Lopez and E. Acha, "Tuning of Phase-Locked Loops for Power Converters Under Distorted Utility Conditions," in IEEE Transactions on Industry Applications, vol. 45, no. 6, pp. 2039-2047, Nov.-dec. 2009. doi: 10.1109/TIA.2009.2031790 and three reference frame transformation blocks, namely, a direct (8.5) and an inverse Clarke transformation (8.6) and an inverse Park transformation (8.7).

As it can be appreciated, the Clarke transformation block (8.5), is connected to the electrical grid (1) at its input and its outputs are connected to the grid impedance identification block (8.3) and the current controller (8.2). The inputs of the inverse Park transformation block (8.7) are the reference current, $i_{ref}$, and the output of the PLL (8.4). The output of such block is connected to the current controller (8.2). The input of the inverse Clarke transformation block (8.6) is the output of the noise-shaped modulator (8.1) and the output of said block is connected to the power converter (5).

Finally, the grid impedance identification block (8.3) is connected to Clarke transformation block (8.5) and to the noise-shaped modulator (8.1) at its inputs, and its output is connected to the current controller (8.2). The current controller (8.2) is connected to the Clarke transformation block (8.5), the inverse Park transformation (8.7) and the grid impedance identification block (8.3) at its inputs, and its output is connected to the noise-shaped modulator (8.1). The noise-shaped modulator (8.1) is connected to the current controller (8.2) at its input, and its outputs are connected to the inverse Clarke transformation (8.6) and to the grid impedance identification block (8.3). The PLL (8.4) is connected to the output of the LCL filter (10) at its input, and its output is connected to the inverse Park transformation (8.7).

In both examples of figures 4 and 5, the value of elements of the LCL are the following: the $L_1$ is 3.75 mH, the value of the $L_2$ is 3.75 mH and the value of the C is 15 $\mu$F. The electrical grid (1) is a 110-V 60-Hz three-phase micro-grid of the main electrical grid with a reactive and a resistive component in the grid impedance of value 2.5 mH and 2.5 Ohm, respectively. Such electrical grid is implemented using a three-phase AC source in series with an impedance.

Further, in these examples, the digital controller (8) comprises the required initialization variables to execute the proposed estimation method (100), namely the known factor of the transfer function, $G_{known}(z)$; the notch filter; the initial current controller parameters; and the PLL parameters.

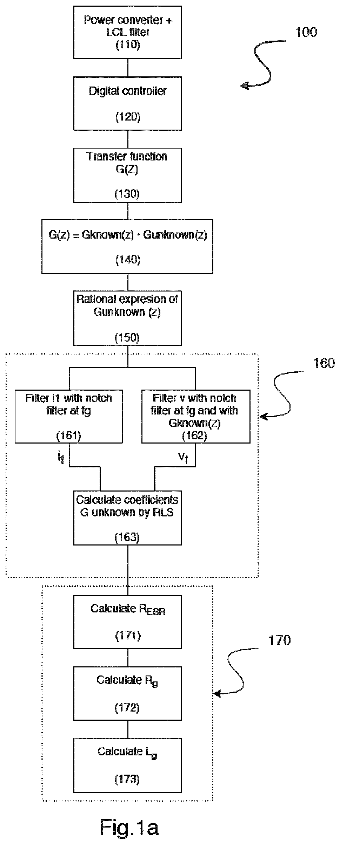

*Figure 1a-1b: Method (100) for estimating the electrical parameters of a grid (1)*

Figure 1a shows a flowchart of the steps comprised in the method:

Step a) of the method provides (110) a power converter (5) and an LCL filter (10), being the LCL filter (10) modeled with two inductors ($L_1$, $L_2$), and a capacitor (C). In this example, the power converter (5) is connected to the grid (1) by means of said an LCL filter (10).

The power converter (5) comprises a reference voltage v (9) as an input and a power converter equivalent series resistance $R_{ESR}$ (6), as it can be shown in the example of figure 4.

Next step b) of the method provides (120) a digital controller and in step c) said digital controller (8) estimates (130), as a zero-pole-gain model, the transfer function G(z) of the combination of the power converter (5), the LCL filter (10) and the electrical grid (1) through the processing module. The estimated function comprising two sampling-zeros $z_1$ and $z_2$; a pole that represents a computational delay of the digital controller (8), a pole at low frequencies $p_1$; two resonant poles $p_2$ and $p_3$ and a constant gain K:

$$G(z) = \frac{i_1}{v} = K \cdot \frac{(z - z_1) \cdot (z - z_2)}{z \cdot (z - p_1) \cdot (z - p_2) \cdot (z - p_3)}$$

Further in step d), the method (100), through the digital controller (8), separates (140) the transfer function G(z) in two parts, $G_{known}(z)$ and $G_{unknown}(z)$, wherein:

- the transfer function G(z) is the multiplication of both parts,
- $G_{known}(z)$ comprises the terms of the function independent of the changes in the grid impedance $Z_g$ (2), the LCL filter (10) parameters, the computational delay of the digital controller (8) and/or the equivalent series resistance $R_{ESR}$ (6) of the power converter (5):

$$G_{known}(z) = \frac{(z - z_1) \cdot (z - z_2)}{z}$$

- and $G_{unknown}(z)$ is a third-order all-pole transfer function comprising the resonant poles, the DC pole and the gain:

$$G_{unknown}(z) = \frac{K}{(z - p_1) \cdot (z - p_2) \cdot (z - p_3)}$$

Later in step e), the method (100), through the digital controller (8), converts (150) the zero-pole-gain model of the function $G_{unknown}(z)$ to a rational expression in the variable z:

$$G_{unknown}(z) = \frac{n_1}{z^3 + m_1 z^2 + m_2 z + m_3}$$

Subsequently in step f), the method (100), through the digital controller (8), obtains (160) the values of $m_1$, $m_2$, $m_3$, and $n_1$ following the next sub-steps:

f-i) filtering (161) the current $i_1$ (4) with a notch filter tuned at the fundamental grid frequency $f_g$ to remove the grid frequency components, i.e, $v_g$ is equal to zero , obtaining $i_f$,

f-ii) filtering (162) the voltage v (9) with $G_{known}(z)$ and a notch filter tuned at the fundamental grid frequency $f_g$ to remove the grid frequency components, i.e, vg is equal to zero, obtaining vf,

f-iii) estimating (163), by means of a recursive least squares, RLS, estimation algorithm, a vector C(k), being k a natural number, that comprises the coefficients of $G_{unknown}(z)$

$$C(k) = [m_1 \ m_2 \ m_3 \ n_1]^T$$

being $G_{unknown}(z)$:

$$G_{unknown}(z) = \frac{i_f}{v_f}$$

Wherein in this particular example, for two consecutive k's the results are:

$$C(1) = [-2.5561 \quad 2.4624 \quad -0.8916 \quad 0.8218]^T$$

$$C(2) = [-2.5573 \quad 2.4630 \quad -0.8911 \quad 0.8161]^T$$

Finally in step g), the method (100), through the digital controller (8), obtains (170) the physical parameters that model the power converter (5) from the vector C(k), following the next sub-steps:

g-i) calculating (171) the value of the equivalent series resistance $R_{ESR}$ (6) in DC conditions, i.e, z equal to 1

$$G(z)|_{z=1} = \frac{1}{(R_{ESR} + R_g)}$$

and disconnecting the power converter (5) from the grid ($R_g$ = 0):

$$R_{ESR} = \frac{1}{G(1)} = 1.5 \, Ohm$$

g-ii) calculating (172) the value of $R_g$ in DC conditions, i.e., z equal to 1 and connecting the power converter (5) to the grid:

$$R_g = \frac{1}{G(1)} - R_{ESR} = 2.4 \, Ohm$$

g-iii) calculating (173) the grid inductance $L_g$ from the values $L_1$, $L_2$, C and the resonant frequency of the system $\omega_{res}$:

$$L_g = \frac{L_1 L_2 - \frac{1}{\omega_{res}^2 C}(L_1 + L_2)}{\frac{1}{\omega_{res}^2 C} - L_2} = 0.1mH$$

wherein the resonant frequency of the system is calculated from the sampling period $T_s$ of the power converter (5) and the poles of $G_{unknown}(z)$, namely, the resonant poles $p_2$ and $p_3$:

$$\omega_{res} = \frac{1}{2T_s}(|\ln p_2 + \ln p_3|) = 5955 \, rads/s$$

The estimation of the electrical parameters of a grid (1) requires a power converter (5) that is connected to such grid (1) by means of an LCL filter (10). Such filter is required to avoid that undesired components reach the power converter (5).

The next step of the method is calculating the transfer function of the system, understanding the system as the combination of the power converter (5), the LCL filter (10) and the grid (1) itself. This transfer function is proposed as a zero-pole-gain model with two zeros, three poles and a gain.

Afterwards, the transfer function is separated in two factors such that, when they are multiplied, result in the complete transfer function. The first factor comprises several known terms that are independent of the changes in the grid impedance $Z_g$ (2), the computational delay of the digital controller (8), the LCL filter (10) and/or the equivalent series resistance $R_{ESR}$ (6) of the power converter (5); comprising such factor all the zeros and the delay pole of the zero-pole-gain model. The second factor comprises the rest of the components that are unknown, i.e. the gain and the poles of the transfer function.

Once the unknown term has been estimated, it is then converted into a third-order rational expression. The unknown coefficients of the rational expression are obtained by means of a recursive least squares (RLS) algorithm using the filtered versions of the signals $i_1$ (4) and $v$ (9) as inputs: both signals are filtered by a notch filter tuned at the fundamental frequency and v is further with the known term of the transfer function.

Finally, the electrical parameters are obtained (170): firstly, from the estimated coefficients, considering DC conditions and disconnecting the power converter (5) from the grid (1), the value of the equivalent series resistance (6) is calculated (171); after that, the power converter (5) is again connected to the grid (1) so that the value of the resistive $R_g$ component of the grid impedance $Z_g$ (2) is calculated (172); and lastly, the reactive $L_g$ component of the grid impedance $Z_g$ (2) is calculated (173) taking into account the values of the LCL filter (10) components, the sampling period of the system and the poles of the transfer function.

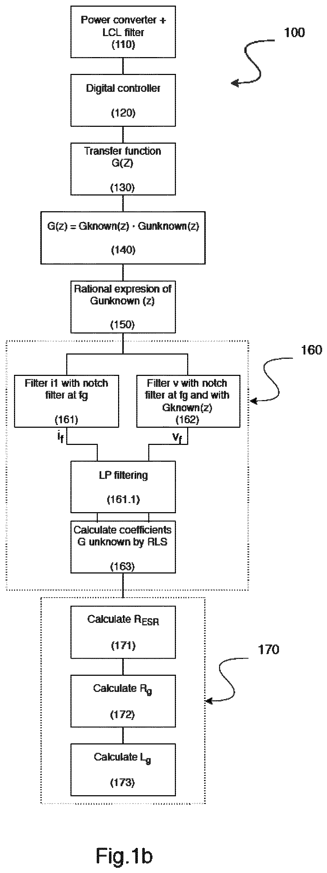

In Figure 1b it is shown a further example of the method of the invention. It can be appreciated that this example is similar to the example of figure 1a with the exception that after filtering the signals v (9) and $i_1$ (4) with the notch filter (both signals) and with the known factor of the transfer function (only v), they are also filtered (161.1) with a low-pass filter to eliminate the high-frequency undesired components.

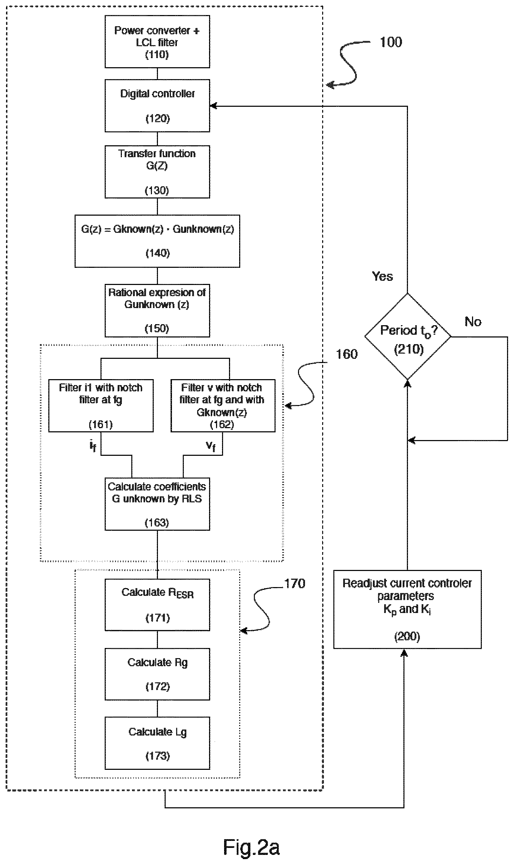

*Figures 2a-2b: Method (100) for improving the transient response and the steady state performance from the estimated electrical parameters of a grid (1)*

Figures 2a-2b show further examples of the method of the invention. In particular, said examples comprise further steps of the flowchart depicted in figure 1a to incorporate the step of readjusting the parameters of the current controller (8.2) thanks to the digital controller (8).

The digital controller (8), which is configured to command the power converter (5), comprises a current controller (8.2) module as the digital controller (8) shown in figure 5. Thanks to the method (100) for estimating the grid impedance, it is possible to readjust periodically the intrinsic parameters of the current controller (8.2), which advantageously improves the transient response and the steady state performance of the power converter. The periodicity is defined by means of an optimization period $t_o$, which is selectable.

In the example of Figure 2a, the current controller (8.2) is a proportional-integral controller PI, and the parameters that define its bandwidth and robustness are two different gains, a proportional gain $K_p$ and an integral gain $K_i$.

As it can be seen in such figure, after completing the estimation of the $R_{ESR}$, $R_g$ and $L_g$, a new step of readjusting (200) the gains $K_p$ and $K_i$ appears through the processing module. This readjustment is done according to the values of $R_{ESR}$, $R_g$ and $L_g$. In this example, $K_p$ and $K_i$ are adjusted as described in the following document A. G. Yepes, A. Vidal, J. Malvar, O. López and J. Doval-Gandoy, "Tuning Method Aimed at Optimized Settling Time and Overshoot for Synchronous Proportional-Integral Current Control in Electric Machines," in IEEE Transactions on Power Electronics, vol. 29, no. 6, pp. 3041-3054, June 2014. doi: 10.1 109/TPEL.2013.2276059:

$$K_p = \frac{4}{100}\, 2\pi f_s \left(R_g + R_{ESR}\right) = 3770$$

$$K_i = \frac{4}{100}\, 2\pi f_s \left(L_1 + L_2 + L_g\right) = 18$$

After a period $t_o$ predefined, the method (100) is again performed to readjust anew the gains of the current controller (8.2). In this particular example, the optimization period $t_o$ is less than five seconds. Thus, the new values of $R_g$ and $L_g$ are 2.5 Ohms and 2.5 mH. Finally, $K_p$ and $K_i$ is adjusted again as above indicated:

$$K_p = \frac{4}{100}\, 2\pi f_s \left(R_g + R_{ESR}\right) = 10053$$

$$K_i = \frac{4}{100}\, 2\pi f_s \left(L_1 + L_2 + L_g\right) = 23$$

In a particular example, the digital controller (8) is a proportional-resonant controller, PR. The parameters to be adjusted of such type of digital controller (8) are the same as the ones of the proportional-integral controller PI.

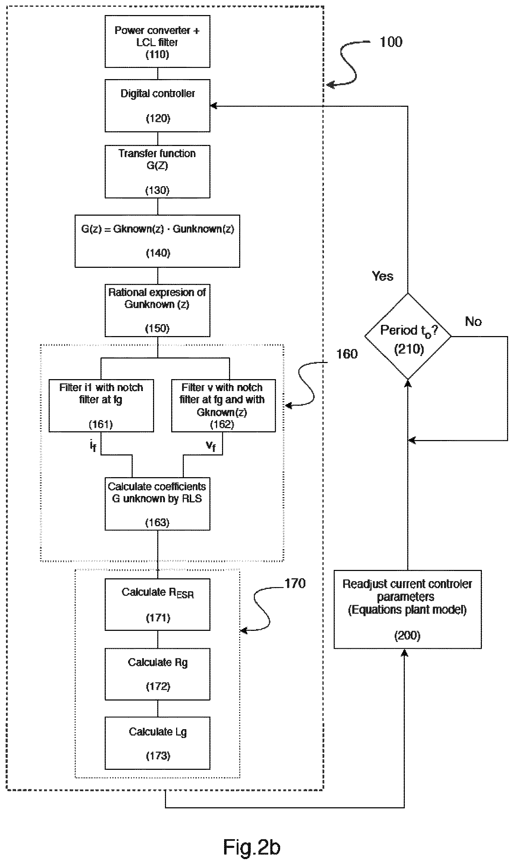

Figure 2b shows an example when the digital controller (8) is a state-space controller, being the results similar for other types of high-order controllers, as the predictive ones. In such cases, the parameters that can be readjusted are the equations that describe the plant model of such controllers (8), where parameters $R_g$ and $L_g$ are updated according to the values obtained by the method (100).

The equations that describe the plant are:

$$\frac{dx(t)}{dt} = \begin{pmatrix} -\dfrac{R_g}{L_1} & 0 & \dfrac{1}{L_1} \\ 0 & -\dfrac{R_{ESR}}{L_2} & -\dfrac{1}{L_2} \\ -\dfrac{1}{C} & \dfrac{1}{C} & 0 \end{pmatrix} x(t) + \begin{pmatrix} 0 \\ \dfrac{1}{L_2} \\ 0 \end{pmatrix} v'_d(t)$$

$$i_1(t) = \begin{pmatrix} 1 & 0 & 0 \end{pmatrix} x(t)$$

$$x(t) = \begin{pmatrix} i_1 \\ i_2 \\ v_c \end{pmatrix}$$

Where $v'_d(t)$ is the continuous-time output voltage of the VSC, $i_1$ is the grid-side current, $i_2$ is the converter-side current, and $v_c$ is the capacitor voltage in the LCL filter.

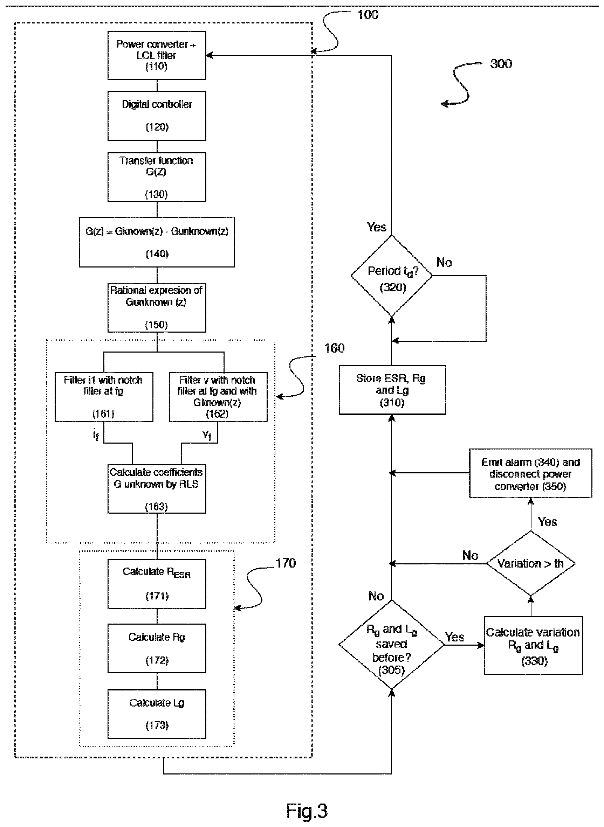

*Figure 3: Method (300) for detecting islanding conditions from the estimated electrical parameters of a grid (1)*

As it was explained in the background, during the operation of a power converter it must be taken into account islanding conditions; that is, the situation in which the power converter powers a micro-grid to which it is connected while the power of the main grid is no longer present. Islanding can be dangerous to utility workers, who may not realize that a circuit is still powered. Thus, detecting such islanding conditions is essential to avoid accidents.

Figure 3 shows an example of the invention which solves the above problem. In particular, it is shown a flowchart of a method (300) for detecting islanding conditions measuring periodically variations in the grid impedance $Z_g$ (2) that is estimated by the method (100). In this example, the method (300) is also performed through the digital controller (8). The period to calculate the variations, $t_d$, is selectable. In this particular example, $t_d$ is lower than five seconds.

According to different norms, islanding condition exists when a variation in the grid impedance is greater than a certain threshold. Such threshold depends on the norm that is being applied. In this particular example, the threshold is 1 Ohm.

As it can be seen in figure 3, after completing the method (100) wherein $R_{ESR}$, $R_g$ and $L_g$, are estimated, the method (300) further determinates (305) if the components of the grid impedance $Z_g$ (2), i.e. $R_g$ and $L_g$, were saved before:

- If such components were not saved before, they are saved (310) within a certain memory storage device, for example, a hard-disk. After a determination period $t_d$, the method (100) is again performed (320).

- If such components were saved before, the new components estimated are compared (330) with the saved ones to calculate the variation:

    ◦ if the variation is below the threshold, the new components are saved (310) and, after a determination period $t_d$, the method (100) is again performed (320). In this example the threshold is 1 Ohm.
    ◦ If the variation is above the threshold, islanding conditions are detected. Then, an alarm is emitted (340) informing the utility worker to avoid a possible accident and the power converter (5) is disconnected (350) from the grid (1). In an example not shown in the figure 3, the method finishes once the alarm is emitted. In the example shown in figure 3, the new components are saved (310) and, after a determination period $t_d$, the method (100) is again performed (320).

In this example, the values calculated on the example of figure 1a are saved in the hard-disk. Then, the digital controller waits 5 seconds and performs again the method (100), obtaining the new values of $R_g$ and $L_g$: 2.5 Ohms and 2.5 mH.

Then, the variation in the grid impedance $\Delta Z_g$ is calculated as follows:

$$\Delta R_g = R_g(t) - R_g(t - t_d)$$

$$\Delta L_g = L_g(t) - L_g(t - t_d)$$

$$\Delta Z_g = \sqrt{\Delta R_g^2 + \left(2\pi\omega_g \Delta L_g\right)^2}$$

As the variation is higher than the threshold, the processing module emits (340) an acoustic alarm and disconnects (350) the power converter (5) by switching off the power switch (10).

*Figure 4: Simulation model of the components needed for estimating the electrical parameters of a grid (1)*

Figure 4 depicts a simulation model of the combination of the power converter (5), the LCL filter (10) and the grid (1). As it can be seen, the input of the power converter (5) is the reference voltage v (9) and it is commanded by a digital controller (8), which is represented as an extra pole in the transfer function due to the delay it involves. The power converter (5), besides, is represented as a zero order hold module (7) in series with an equivalent series resistance (6). The LCL filter (10), on the other hand, comprises two inductors $L_1$ and $L_2$ and a capacitor C, as it can be noticed from the figure. Finally, the grid (1) comprises an impedance $Z_g$ (2), through which a current $i_1$ (4) flows, and an AC voltage source (3). In this example, a computer is connected to the digital controller.

*Figure 5: Electrical scheme of the components needed for estimating the electrical parameters of a grid (1) wherein the modules of the digital controller (8) are detailed.*

Figure 5 shows a scheme of the system where the digital controller (8) is depicted in detail. It comprises a noise shaped modulator (8.1), a current controller (8.2), a grid impedance identification element (8.3), a phase locked loop (8.4), PLL, and three reference frame transformation elements (8.5). The noise shaped modulator (8.1) is configured to generate the reference voltage v (9) as the input of the power converter (5). Besides, in this particular example the power converter (5) and the LCL filter (10) can be connected and disconnected from the grid (1) by means of a switch element (11).
Internally, the digital controller (8) executes the PLL (8.4) to obtain the phase of the grid voltage. After that, it transforms the measured grid current using the reference frame transformation element (8.5) and executes the current controller (8.2) to obtain a modulating signal that is then converted into a synthesizable vector. Afterward, the digital controller (8) converts such vector into firing triggering signals of the transistors of the power converter (5) and, finally, it estimates the grid impedance Zg (2) by means of the grid impedance identification element (8.3).

## Claims

1.  A method (100) for estimating the electrical parameters of a grid (1) to which a power converter (5) is connected by means of a LCL filter (10), wherein

    the electrical parameters comprise a resistive $R_g$ and a reactive $j\omega_g L_g$ components of the grid impedance $Z_g$ (2), where $\omega_g$ is the grid angular frequency in radians per second,
    the electrical grid is modeled as an AC-voltage source $v_g$ (3) in series with the impedance $Z_g$ (2), and
    a current $i_1$ (4) flows through $Z_g$ (2),

    the method (100) comprising the steps of:

    a) estimating (130) by a digital controller (8), as a zero-pole-gain model, a transfer function G(z) of a system comprising the power converter (5) connected to the electrical grid (1) by means of the LCL filter (10), wherein

    the digital controller (8) comprises processing means configured to estimate the electrical parameters of the grid (1);
    the LCL filter (10) is modeled with two inductors ($L_1$, $L_2$), and a capacitor (C); and
    the power converter (5) comprises a reference voltage v (9) as an input and a power converter equivalent series resistance $R_{ESR}$ (6); and

    wherein the function G(z) comprises two sampling-zeros $z_1$ and $z_2$; a pole that represents a computational delay of the digital controller (8) z; a pole at low frequencies $p_1$; two resonant poles $p_2$ and $p_3$ and a constant gain K:

$$G(z) = \frac{i_1}{v} = K \cdot \frac{(z - z_1) \cdot (z - z_2)}{z \cdot (z - p_1) \cdot (z - p_2) \cdot (z - p_3)}$$

b) separating (140) by the digital controller (8) the transfer function G(z) in two parts, $G_{known}(z)$ and $G_{unknown}(z)$, wherein:

- the transfer function G(z) is the multiplication of both parts,
- $G_{known}(z)$ comprises the terms of the function independent of the changes in the grid impedance $Z_g$ (2), the LCL filter (10) parameters and/or the equivalent series resistance $R_{ESR}$ (6) of the power converter (5):

$$G_{known}(z) = \frac{(z - z_1) \cdot (z - z_2)}{z}$$

- and $G_{unknown}(z)$ is a third-order all-pole transfer function comprising the resonant poles, the DC pole and the gain:

$$G_{unknown}(z) = \frac{K}{(z - p_1) \cdot (z - p_2) \cdot (z - p_3)}$$

c) converting (150) by the digital controller (8), the zero-pole-gain model of the function $G_{unknown}(z)$ to a rational expression in the variable z:

$$G_{unknown}(z) = \frac{n_1}{z^3 + m_1 z^2 + m_2 z + m_3}$$

d) obtaining (160) by the digital controller (8), the values of $m_1$, $m_2$, $m_3$, and $n_1$ following the next sub-steps:

d-i) filtering (161), by the digital controller (8), the current $i_1$ (4) with a notch filter tuned at the fundamental grid frequency $f_g$ to remove the grid frequency components, obtaining $i_f$,
d-ii) filtering (162), by the digital controller (8), the voltage v (9) with $G_{known}(z)$ and a notch filter tuned at the fundamental grid frequency $f_g$ to remove the grid frequency components, obtaining $v_f$,
d-iii) estimating (163), by the digital controller (8), by means of a recursive least squares, RLS, estimation algorithm, a vector C(k), being k a natural number, that comprises the coefficients of $G_{unknown}(z)$; the RLS estimation algorithm receiving as inputs the current if and the voltage vf, wherein the vector C(k) is:

$$C(k) = [m_1 \ m_2 \ m_3 \ n_1]^T$$

being $G_{unknown}(z)$:

$$G_{unknown}(z) = \frac{i_f}{v_f}$$

e) obtaining (170) by the digital controller (8) the physical parameters that model the power converter (5) from the vector C(k), following the next sub-steps:

e-i) calculating (171) the value of the equivalent series resistance $R_{ESR}$ (6) in DC conditions, i.e, z equal to 1

$$G(z)|_{z=1} = \frac{1}{(R_{ESR} + R_g)}$$

and disconnecting the power converter (5) from the grid (1) to give $R_g$ a value of zero:

$$R_{ESR} = \frac{1}{G(1)|_{power\_converter\_disconnected}}$$

e-ii) calculating (172) the value of $R_g$ in DC conditions, i.e., z equal to 1 and connecting the power converter (5) to the grid (1):

$$R_g = \frac{1}{G(1)|_{power\_converter\_connected}} - R_{ESR}$$

e-iii) calculating (173) the grid inductance $L_g$ from the values $L_1$, $L_2$, C and the resonant frequency of the system $\omega_{res}$:

$$L_g = \frac{L_1 L_2 - \frac{1}{\omega_{res}^2 C}(L_1 + L_2)}{\frac{1}{\omega_{res}^2 C} - L_2}$$

wherein the resonant frequency of the system is calculated from the sampling period $T_s$ of the power converter (5) and the poles of $G_{unknown}(z)$, namely, the resonant poles $p_2$ and $p_3$:

$$\omega_{res} = \frac{1}{2T_s}(|\ln p_2 + \ln p_3|).$$

2. The method (100) according to claim 1, wherein the method further comprises a sub-step between the stages d-ii) and d-iii) of filtering (161.1) $v_f$ (9) and $i_f$ (4) with a low-pass filter.

3. The method (100) according to any of the preceding claims, wherein the power converter (5) is a voltage source converter (*VSC*) modeled as a zero order hold (7), *ZOH*, in series with the equivalent series resistance $R_{ESR}$ (6).

4. The method (100) according to any of the preceding claims, further comprising the following steps:

   - readjusting (200) intrinsic parameters of a current controller (8.2) based on the calculated physical parameters,
   - after an optimization period, $t_o$, performing (210) the steps a) to e) of the method (100) obtaining an update of the physical parameters and performing the previous step with the updated physical parameters.

5. The method (100) according to claim 4, wherein the intrinsic parameters of the current controller (8.2) are a proportional gain $K_p$ and an integral gain $K_i$.

6. The method (100) according to any of the preceding claims, wherein in steps a) and e-ii) the power converter (5) is connected to the grid by means of a switch element (11) and wherein in step e-i) the power converter (5) is disconnected from the grid and short circuit its output by means of said switch element (11).

7. Method (300) for detecting islanding conditions of a grid (1) comprising the following steps:

   1) performing the method (100) for estimating the electrical parameters of the grid (1) according to any of the preceding claims,
   2) storing (310) the physical parameters within a memory,
   3) after a determination period, $t_d$, performing (320) the steps a) to e) of the method (100) for estimating the electrical parameters of a grid according to any of the preceding claims, obtaining an update of the physical parameters,
   4) comparing (330) the stored physical parameters and the updated physical parameters,
   5) if the variations between the stored physical parameters and the updated physical parameters are greater than a threshold, emitting (340) an alarm as islanding conditions are detected.

EP 3 637 574 B1

8. The method (300) according to claim 7, wherein if the variations between the physical parameters and the updated physical parameters are lower or equal than the threshold, iteratively performing the following steps:

   i) storing the updated physical parameters, and
   ii) repeating the steps 3) to 5) until the stored physical parameters and the updated physical parameters are greater than the threshold.

9. The method (300) according to claims 7 or 8, wherein the last step of the method further comprises disconnecting (350) the power converter (5) from the grid (1).

10. The method (300) according to any of the claims 7 to 9, wherein $t_d$ is from one millisecond to five seconds and/or the threshold is from 0.1 to 1 ohms.

11. System adapted to estimate the electrical parameters of a grid (1) comprising a power converter (5), an LCL filter (10), a digital controller (8) and means configured to

   - perform steps of the method (100) of any of the claims 1 to 6, and/or
   - perform steps of the method (300) of any of the claims 7 to 10.

12. The system according to claim 11, wherein the digital controller (8) comprises a noise-shaped modulator (8.1), a phase locked loop (8.4) or PLL, at least one reference frame transformation element (8.5), a current controller (8.2) and a grid impedance identification element (8.3).

13. The system according to claim 12, wherein the noise-shaped modulator (8.1) is configured to generate the reference voltage $v$ (9) that the power converter (5) receives at its input.

14. A computer program comprising instructions which, when the program is executed by a system according to any of the claims 11 to 13, cause the system to carry out

   - the steps of the method (100) of any of the claims 1 to 6, and/or
   - the steps of the method (300) of any of the claims 7 to 10.

15. A computer-readable medium having stored thereon the computer program of claim 14.


**Patentansprüche**

1. Verfahren (100) zum Schätzen der elektrischen Parameter eines Stromnetzes (1), mit dem ein Stromrichter (5) mit Hilfe eines LCL-Filters (10) verbunden ist, wobei

   die elektrischen Parameter eine resistive Komponente $R_g$ und eine reaktive Komponente $j\omega_g L_g$ der Netzimpedanz $Z_g$ (2) umfassen, wo $\omega_g$ die Winkelfrequenz des Stromnetzes in Radianten pro Sekunde ist, das Stromnetz als Wechselspannungsquelle $v_g$ (3) in Reihe mit der Impedanz $Z_g$ (2) modelliert ist, und ein Strom $i_1$ (4) durch $Z_g$ (2) fließt,

   wobei das Verfahren (100) die folgenden Schritte umfasst:

   a) Schätzen (130), durch einen Digitalregler (8) als Pol-Nullstellen-Modell, einer Übertragungsfunktion G(z) eines Systems mit dem Stromrichter (5), der mit Hilfe des LCL-Filters (10) mit dem Stromnetz (1) verbunden ist, wobei

      der Digitalregler (8) Verarbeitungsmittel umfasst, die dazu ausgebildet sind, die elektrischen Parameter des Stromnetzes (1) zu schätzen; das LCL-Filter (10) mit zwei Induktoren ($L_1$, $L_2$) und einem Kondensator (C) modelliert ist; und der Stromrichter (5) eine Referenzspannung $v$ (9) als Eingang und einen dem Stromrichter äquivalenten Reihenwiderstand $R_{ESR}$ (6) umfasst; und wobei die Funktion G(z) zwei Abtastnullstellen $z_1$ und $z_2$ umfasst; einen Pol, der eine Latenz z des Digitalreglers (8) repräsentiert; einen Pol bei niedrigen Frequenzen $p_1$; zwei Resonanzpole $p_2$ und $p_3$ und eine

15

konstante Verstärkung K:

$$G(z) = \frac{i_1}{v} = K \cdot \frac{(z - z_1) \cdot (z - z_2)}{z \cdot (z - p_1) \cdot (z - p_2) \cdot (z - p_3)}$$

b) Trennen (140), durch den Digitalregler (8), der Übertragungsfunktion G(z) in zwei Teile, $G_{bekannt}(z)$ und $G_{unbekannt}(z)$, wobei:

- die Übertragungsfunktion G(z) die Multiplikation beider Teile ist,
- $G_{bekannt}(z)$ die Terme der Funktion unabhängig von den Änderungen in der Netzimpedanz $Z_g$ (2), den Parametern des LCL-Filters (10) und/oder dem äquivalenten Reihenwiderstand $R_{ESR}$ (6) des Stromrichters (5) umfasst:

$$G_{bekannt}(z) = \frac{(z - z_1) \cdot (z - z_2)}{z}$$

- und $G_{unbekannt}(z)$ eine allpolige Übertragungsfunktion dritter Ordnung ist, welche die Resonanzpole, den Gleichspannungspol und die Verstärkung umfasst:

$$G_{unbekannt}(z) = \frac{K}{(z - p_1) \cdot (z - p_2) \cdot (z - p_3)}$$

c) Umwandeln (150), durch den Digitalregler (8), des Pol-Nullstellen-Modells der Funktion $G_{unbekannt}(z)$ in einen rationalen Ausdruck bei der Variablen z:

$$G_{unbekannt}(z) = \frac{n_1}{z^3 + m_1 z^2 + m_2 z + m_3}$$

d) Erhalten (160), durch den Digitalregler (8), der Werte $m_1$, $m_2$, $m_3$ und $n_1$ im Anschluss an die nächsten Unterschritte:

d-i) Filtern (161), durch den Digitalregler (8), des Stromes $i_1$ (4) mit einem auf die fundamentale Netzfrequenz $f_g$ abgestimmten Kerbfilter, um die Netzfrequenzkomponenten zu entfernen, wodurch man $i_f$ erhält,
d-ii) Filtern (162), durch den Digitalregler (8), der Spannung v (9) mit $G_{bekannt}(z)$ und einem auf die fundamentale Netzfrequenz $f_g$ abgestimmten Kerbfilter, um die Netzfrequenzkomponenten zu entfernen, wodurch man vf erhält,
d-iii) Schätzen (163), durch den Digitalregler (8), mit Hilfe eines Schätzalgorithmus der rekursiven kleinsten Quadrate, RLS, eines Vektors C(k), wobei k eine natürliche Zahl ist, der die Koeffizienten von $G_{unbekannt}(z)$ umfasst; wobei der RLS-Schätzalgorithmus als Eingänge die Stromstärke if und die Spannung vf erhält, wobei der Vektor C(k) wie folgt lautet:

$$C(k) = [m_1 m_2 m_3 n_1]^T$$

wobei $G_{unbekannt}(z)$ wie folgt lautet:

$$G_{unbekannt}(z) = \frac{i_f}{v_f}$$

e) Erhalten (170), durch den Digitalregler (8), der physikalischen Parameter, die den Stromrichter (5) aus dem Vektor C(k) modellieren, im Anschluss an die nächsten Unterschritte:

e-i) Berechnen (171) des Wertes des äquivalenten Reihenwiderstands $R_{ESR}$ (6) unter Gleichstrombedingungen, d.h. z gleich 1

$$G(z)I_{z=1} = \frac{1}{\left(R_{ESR} + R_g\right)}$$

und Trennen des Stromrichters (5) von dem Stromnetz (1), um $R_g$ den Wert Null zu geben:

$$R_{ESR} = \frac{1}{G(1)I_{Stromrichter\_getrennt}}$$

e-ii) Berechnen (172) des Wertes von Rg unter Gleichstrombedingungen, d.h. z gleich 1, und Verbinden des Stromrichters (5) mit dem Stromnetz (1):

$$R_g = \frac{1}{G(1)I_{Stromrichter\_verbunden}} - R_{ESR}$$

e-iii) Berechnen (173) der Netzinduktivität $L_g$ aus den Werten $L_1$, $L_2$, C und der Resonanzfrequenz des Systems $\omega_{res}$:

$$L_g = \frac{L_1 L_2 - \frac{1}{\omega_{res}^2 C}(L_1 + L_2)}{\frac{1}{\omega_{res}^2 C} - L_2}$$

wobei die Resonanzfrequenz des Systems aus der Abtastperiode $T_s$ des Stromrichters (5) und den Polen von $G_{unbekannt}(z)$, nämlich aus den Resonanzpolen $p_2$ und $p_3$ berechnet wird:

$$\omega_{res} = \frac{1}{2T_s}(|ln\,p_2 + ln\,p_3|).$$

2. Verfahren (100) nach Anspruch 1, wobei das Verfahren ferner einen Unterschritt zwischen den Stufen d-ii) und d-iii) der Filterung (161.1) vf (9) und if (4) mit einem Tiefpassfilter umfasst.

3. Verfahren (100) nach einem der vorhergehenden Ansprüche, wobei der Stromrichter (5) ein selbstgeführter Umrichter (Voltage Source Converter - VSC) ist, der als Halteglied nullter Ordnung (7), Zero Order Hold (ZOH), modelliert ist, das mit dem äquivalenten Reihenwiderstand $R_{ESR}$ (6) in Reihe geschaltet ist.

4. Verfahren (100) nach einem der vorhergehenden Ansprüche, das ferner die folgenden Schritte umfasst:

   - Nachjustieren (200) intrinsischer Parameter eines Stromreglers (8.2) auf der Grundlage der berechneten physikalischen Parameter,
   - nach einem Optimierungszeitraum, $t_o$, Durchführen (210) der Schritte a) bis e) des Verfahrens (100), Aktualisieren der physikalischen Parameter und Durchführen des vorherigen Schrittes mit den aktualisierten physikalischen Parametern.

5. Verfahren (100) nach Anspruch 4, wobei es sich bei den intrinsischen Parametern des Stromreglers (8.2) um eine Proportionalverstärkung $K_p$ und eine Integralverstärkung $K_i$ handelt.

6. Verfahren (100) nach einem der vorhergehenden Ansprüche, wobei der Stromrichter (5) in den Schritten a) und e-ii) mit Hilfe eines Schaltelements (11) mit dem Stromnetz verbunden wird, und wobei der Stromrichter (5) in Schritt e-i) von dem Stromnetz getrennt wird und mit Hilfe des Schaltelements (11) ein Kurzschluss ausgegeben wird.

7. Verfahren (300) zum Feststellen von Bedingungen der Inselbildung eines Stromnetzes (1), mit den folgenden Schritten:

1) Durchführen des Verfahrens (100) zum Schätzen der elektrischen Parameter des Stromnetzes (1) nach einem der vorhergehenden Ansprüche,

2) Speichern (310) der physikalischen Parameter in einem Speicher,

3) nach einem Ermittlungszeitraum, $t_d$, Durchführen (320) der Schritte a) bis e) des Verfahrens (100) zum Schätzen der elektrischen Parameter eines Stromnetzes nach einem der vorhergehenden Ansprüche, Aktualisieren der physikalischen Parameter,

4) Vergleichen (330) der gespeicherten physikalischen Parameter und der aktualisierten physikalischen Parameter,

5) wenn die Schwankungen zwischen den gespeicherten physikalischen Parametern und den aktualisierten physikalischen Parametern größer sind als ein Schwellenwert, Ausgabe (340) eines Alarms, da Bedingungen einer Inselbildung festgestellt werden.

8. Verfahren (300) nach Anspruch 7, wobei im Falle, dass die Schwankungen zwischen den physikalischen Parametern und den aktualisierten physikalischen Parametern kleiner oder gleich dem Schwellenwert sind, die folgenden Schritte iterativ durchgeführt werden:

i) Speichern der aktualisierten physikalischen Parameter, und

ii) Wiederholen der Schritte 3) bis 5), bis die gespeicherten physikalischen Parameter und die aktualisierten physikalischen Parameter größer sind als der Schwellenwert.

9. Verfahren (300) nach Anspruch 7 oder 8, wobei der letzte Schritt des Verfahrens ferner das Trennen (350) des Stromrichters (5) von dem Stromnetz (1) umfasst.

10. Verfahren (300) nach einem der Ansprüche 7 bis 9, wobei $t_d$ von 1 Millisekunde bis 5 Sekunden beträgt und/oder der Schwellenwert von 0,1 bis 1 Ohm beträgt.

11. System, das zum Schätzen der elektrischen Parameter eines Stromnetzes (1) ausgelegt ist, das einen Stromrichter (5), ein LCL-Filter (10), einen Digitalregler (8) und Mittel umfasst, die

- zur Durchführung der Schritte des Verfahrens (100) nach einem der Ansprüche 1 bis 6 ausgebildet sind, und/oder
- zur Durchführung der Schritte des Verfahrens (300) nach einem der Ansprüche 7 bis 10 ausgebildet sind.

12. System nach Anspruch 11, wobei der Digitalregler (8) einen rauschgeformten Modulator (8.1), einen Phasenregelkreis (8.4) bzw. PLL, mindestens ein Bezugsrahmen-Transformationselement (8.5), einen Stromregler (8.2) und ein Netzimpedanz-Identifikationselement (8.3) umfasst.

13. System nach Anspruch 12, wobei der rauschgeformte Modulator (8.1) dazu ausgebildet ist, die Referenzspannung v (9) zu erzeugen, die der Stromrichter (5) als Eingang erhält.

14. Computerprogramm mit Anweisungen, die bei Ausführung des Programms durch ein System nach einem der Ansprüche 11 bis 13 bewirken, dass das System Folgendes durchführt:

- die Schritte des Verfahrens (100) nach einem der Ansprüche 1 bis 6, und/oder
- die Schritte des Verfahrens (300) nach einem der Ansprüche 7 bis 10.

15. Computerlesbares Medium, auf dem das Computerprogramm nach Anspruch 14 gespeichert ist.

**Revendications**

1. Un procédé (100) pour estimer les paramètres électriques d'un réseau (1) auquel un convertisseur de puissance (5) est connecté au moyen d'un filtre LCL (10), dans lequel

les paramètres électriques comprennent une composante résistive $R_g$ et une composante réactive $j\omega_g L_g$ de l'impédance de réseau $Z_g$ (2), $\omega_g$ étant la fréquence angulaire de réseau en radians par seconde,

le réseau électrique est modélisé comme étant une source de tension alternative $v_g$ (3) en série avec l'impédance $Z_g$ (2), et
un courant $i_1$ (4) s'écoule à travers $Z_g$ (2),

le procédé (100) comprenant les étapes suivantes :

a) estimer (130) par un contrôleur numérique (8), en tant que modèle à gain de pôle nul, une fonction de transfert $G(z)$ d'un système comprenant le convertisseur de puissance (5) connecté au réseau électrique (1) au moyen du filtre LCL (10),

le contrôleur numérique (8) comprenant des moyens de traitement configurés pour estimer les paramètres électriques du réseau (1) ;
le filtre LCL (10) étant modélisé avec deux inductances ($L_1$, $L_2$) et un condensateur (C) ; et
le convertisseur de puissance (5) comprenant une tension de référence v (9) en tant qu'entrée et une résistance série équivalente $R_{ESR}$ (6) du convertisseur de puissance, et
la fonction $G(z)$ comprenant deux zéros d'échantillonnage $z_1$ et $z_2$ ; un pôle qui représente un retard de calcul du contrôleur numérique (8) z ; un pôle aux basses fréquences $p_1$ ; deux pôles résonants $p_2$ et $p_3$ et un gain constant K :

$$G(z) = \frac{i_1}{v} = K \cdot \frac{(z - z_1) \cdot (z - z_2)}{z \cdot (z - p_1) \cdot (z - p_2) \cdot (z - p_3)}$$

b) séparer (140) par le contrôleur numérique (8) la fonction de transfert $G(z)$ en deux parties, $G_{connu}(Z)$ et $G_{inconnu}(Z)$, dans laquelle :

- la fonction de transfert $G(z)$ est la multiplication des deux parties,
- $G_{connu}(Z)$ comprend les termes de la fonction indépendants des changements de l'impédance du réseau $Z_g$ (2), des paramètres du filtre LCL (10) et/ou de la résistance série équivalente $R_{ESR}$ (6) du convertisseur de puissance (5) :

$$G_{connu}(z) = \frac{(z - z_1) * (z - z_2)}{z}$$

- et $G_{inconnu}(Z)$ est une fonction de transfert tous pôles du troisième ordre comprenant les pôles résonants, le pôle DC et le gain :

$$G_{inconnu}(z) = \frac{K}{(z - p_1) * (z - p_2) * (z - p_3)}$$

c) convertir (150) par le contrôleur numérique (8), le modèle à gain de pôle nul de la fonction $G_{inconnu}(Z)$ en une expression rationnelle dans la variable z :

$$G_{inconnu}(z) = \frac{n_1}{z^3 + m_1 z^2 + m_2 z + m_3}$$

d) obtention (160) par le contrôleur numérique (8), des valeurs de $m_1$, $m_2$ $m_3$ et $n_1$ en suivant les sous-étapes suivantes :

d-i) filtrer (161), par le contrôleur numérique (8), le courant $i_1$ (4) avec un filtre coupe-bande accordé à la fréquence fondamentale de réseau $f_g$ pour éliminer les composantes de fréquence de réseau, obtenant $i_r$,

d-ii) filtrer (162), par le contrôleur numérique (8), la tension v (9) avec $G_{connu}(Z)$ et un filtre coupe-bande accordé à la fréquence fondamentale de réseau $f_g$ pour supprimer les composantes de fréquence de réseau, obtenant vf,

d-iii) estimer (163), par le contrôleur numérique (8), au moyen d'un algorithme d'estimation des moindres carrés récursifs, RLS, un vecteur C(k), k étant un nombre naturel, qui comprend les coefficients de $G_{inconnu}(Z)$; l'algorithme d'estimation RLS recevant en tant qu'entrées le courant $i_r$ et la tension vf, le vecteur C(k) étant :

$$C(k) = [m_1 \ m_2 \ m_3 \ n_1]^T$$

$G_{inconnu}(Z)$ étant :

$$G_{inconnu}(z) = \frac{i_f}{v_f}$$

e) obtenir (170) par le contrôleur numérique (8) les paramètres physiques qui modélisent le convertisseur de puissance (5) à partir du vecteur $C(k)$, en suivant les sous-étapes suivantes :

e-i) calculer (171) la valeur de la résistance série équivalente $R_{ESR}$ (6) dans des conditions DC, c'est-à-dire z égal à 1

$$G(z)|_{z=1} = \frac{1}{(R_{ESR} + R_g)}$$

et déconnecter le convertisseur de puissance (5) du réseau (1) pour donner à $R_g$ une valeur nulle :

$$R_{ESR} = \frac{1}{G(1)|_{convertisseur\_de\_puissance\_déconnecté}}$$

e-ii) calculer (172) la valeur de $R_g$ dans des conditions DC, c'est-à-dire z égal à 1 et connecter le convertisseur de puissance (5) au réseau (1) :

$$R_g = \frac{1}{G(1)|_{convertisseur\_de\_puissance\_connecté}} - R_{ESR}$$

e-iii) calculer (173) l'inductance de réseau $L_g$ à partir des valeurs $L_1$, $L_2$, C et de la fréquence de résonance du système $\omega_{res}$ :

$$L_g = \frac{L_1 L_2 - \dfrac{1}{\omega_{res}^2 C}(L_1 + L_2)}{\dfrac{1}{\omega_{res}^2 C} - L_2}$$

la fréquence de résonance du système étant calculée à partir de la période d'échantillonnage $T_s$ du convertisseur de puissance (5) et des pôles de $G_{inconnu}(Z)$, à savoir les pôles résonants $p_2$ et $p_3$ :

$$\omega_{res} = \frac{1}{2T_s}(|\ln p_2 + \ln p_3|).$$

2. Le procédé (100) selon la revendication 1, dans lequel le procédé comprend en outre une sous-étape entre les étapes d-ii) et d-iii) de filtrage (161.1) $v_f$ (9) et $i_f$ (4) avec un filtre passe-bas.

3. Le procédé (100) selon l'une quelconque des revendications précédentes, dans lequel le convertisseur de puissance (5) est un convertisseur de source de tension (*VSC*) modélisé en tant que maintien d'ordre zéro (7), *ZOH,* en série avec la résistance série équivalente $R_{ESR}$ (6).

4. Le procédé (100) selon l'une quelconque des revendications précédentes, comprenant en outre les étapes suivantes :

   - réajuster (200) des paramètres intrinsèques d'un contrôleur de courant (8.2) en fonction des paramètres physiques calculés,
   - après une période d'optimisation $t_0$, mettre en oeuvre (210) les étapes a) à e) du procédé (100) pour obtenir une mise à jour des paramètres physiques et réaliser l'étape précédente avec les paramètres physiques mis à jour.

5. Le procédé (100) selon la revendication 4, dans lequel les paramètres intrinsèques du contrôleur de courant (8.2) sont un gain proportionnel $K_p$ et un gain intégral $K_i$.

6. Le procédé (100) selon l'une quelconque des revendications précédentes, dans lequel aux étapes a) et e-ii) le convertisseur de puissance (5) est connecté au réseau au moyen d'un élément de commutation (11) et dans lequel à l'étape e-i) le convertisseur de puissance (5) est déconnecté du réseau et court-circuite sa sortie au moyen dudit élément de commutation (11).

7. Procédé (300) pour détecter des conditions d'îlotage d'un réseau (1) comprenant les étapes suivantes :

   1) mettre en oeuvre le procédé (100) d'estimation des paramètres électriques du réseau (1) selon l'une quelconque des revendications précédentes,
   2) stocker (310) les paramètres physiques dans une mémoire,
   3) après une période de détermination, $t_d$, mettre en oeuvre (320) les étapes a) à e) du procédé (100) d'estimation des paramètres électriques d'un réseau selon l'une quelconque des revendications précédentes, obtenir une mise à jour des paramètres physiques,
   4) comparer (330) les paramètres physiques stockés et les paramètres physiques mis à jour,
   5) si les variations entre les paramètres physiques stockés et les paramètres physiques mis à jour sont supérieures à un seuil, émettre (340) une alarme lorsque des conditions d'îlotage sont détectées.

8. Le procédé (300) selon la revendication 7, dans lequel si les variations entre les paramètres physiques et les paramètres physiques mis à jour sont inférieures ou égales au seuil, effectuer de manière itérative les étapes suivantes :

   i) stocker les paramètres physiques mis à jour, et
   ii) répéter les étapes 3) à 5) jusqu'à ce que les paramètres physiques stockés et les paramètres physiques mis à jour soient supérieurs au seuil.

**9.** Le procédé (300) selon les revendications 7 ou 8, dans lequel la dernière étape du procédé comprend en outre la déconnexion (350) du convertisseur de puissance (5) par rapport au réseau (1).

**10.** Le procédé (300) selon l'une quelconque des revendications 7 à 9, dans lequel $t_d$ est compris entre une milliseconde et cinq secondes et/ou le seuil est compris entre 0,1 et 1 ohm.

**11.** Système adapté pour estimer les paramètres électriques d'un réseau (1), comprenant un convertisseur de puissance (5), un filtre LCL (10), un contrôleur numérique (8) et des moyens configurés pour

    - mettre en oeuvre les étapes du procédé (100) selon l'une quelconque des revendications 1 à 6, et/ou
    - mettre en oeuvre les étapes du procédé (300) selon l'une quelconque des revendications 7 à 10.

**12.** Le système selon la revendication 11, dans lequel le contrôleur numérique (8) comprend un modulateur de forme de bruit (8.1), une boucle à verrouillage de phase (8.4) ou PLL, au moins un élément de transformation de référentiel (8.5), un contrôleur de courant (8.2) et un élément d'identification d'impédance de réseau (8.3).

**13.** Le système selon la revendication 12, dans lequel le modulateur de forme de bruit (8.1) est configuré pour générer la tension de référence v (9) que le convertisseur de puissance (5) reçoit à son entrée.

**14.** Un programme informatique comprenant des instructions qui, lorsque le programme est exécuté par un système selon l'une quelconque des revendications 11 à 13, amènent le système à exécuter

    - les étapes du procédé (100) selon l'une quelconque des revendications 1 à 6, et/ou
    - les étapes du procédé (300) selon l'une quelconque des revendications 7 à 10.

**15.** Un support lisible par ordinateur sur lequel est stocké le programme informatique selon la revendication 14.

Power converter +
LCL filter
(110)

100

Digital controller
(120)

Transfer function
G(Z)
(130)

G(z) = Gknown(z) · Gunknown(z)
(140)

Rational expresion of
Gunknown (z)
(150)

160

Filter i1 with notch
filter at fg
(161)

Filter v with notch
filter at fg and with
Gknown(z)
(162)

$i_f$

$v_f$

Calculate coefficients
G unknown by RLS
(163)

Calculate $R_{ESR}$
(171)

170

Calculate $R_g$
(172)

Calculate $L_g$
(173)

Fig.1a

Fig.1b

Fig.2a

Fig.2b

Fig.3

Fig.4

EP 3 637 574 B1

Fig.5

## REFERENCES CITED IN THE DESCRIPTION

### Patent documents cited in the description

- EP 2827157 A1
- EP 1643256 A1

- US 2016252588 A1

### Non-patent literature cited in the description

- **R. H. PARK.** Two-reaction theory of synchronous machines generalized method of analysis-part I. Institute of Electrical Engineers, July 1929, vol. 48, 716-727
- **CLARKE, E.** Circuit Analysis of AC Power Systems. John Wiley & Sons, Inc, 1950, vol. 1
- **D. PEREZ-ESTEVEZ ; J. DOVAL-GANDOY ; A. G. YEPES ; O. LOPEZ ; F. BANEIRA.** Generalized Multi-Frequency Current Controller for Grid-Connected Converters With LCL Filter. *IEEE Transactions on Industry Applications*

- **F. D. FREIJEDO ; J. DOVAL-GANDOY ; O. LOPEZ ; E. ACHA.** Tuning of Phase-Locked Loops for Power Converters Under Distorted Utility Conditions. *IEEE Transactions on Industry Applications,* November 2009, vol. 45 (6), 2039-2047
- **A. G. YEPES ; A. VIDAL ; J. MALVAR ; O. LÓPEZ ; J. DOVAL-GANDOY.** Tuning Method Aimed at Optimized Settling Time and Overshoot for Synchronous Proportional-Integral Current Control in Electric Machines. *IEEE Transactions on Power Electronics,* June 2014, vol. 29 (6), 3041-3054